Europäisches Patentamt

European Patent Office

Office européen des brevets

(11) Veröffentlichungsnummer: **0 256 286 B1**

(12) **EUROPÄISCHE PATENTSCHRIFT**

(45) Veröffentlichungstag der Patentschrift: **02.12.92**

(21) Anmeldenummer: **87109771.3**

(22) Anmeldetag: **07.07.87**

(51) Int. Cl.⁵: **H03H 17/02**

(54) **Filteranordnung.**

(30) Priorität: **14.08.86 DE 3627676**

(43) Veröffentlichungstag der Anmeldung:
**24.02.88 Patentblatt 88/08**

(45) Bekanntmachung des Hinweises auf die
Patenterteilung:
**02.12.92 Patentblatt 92/49**

(84) Benannte Vertragsstaaten:
**DE FR GB SE**

(56) Entgegenhaltungen:

IEEE TRANSACTIONS ON ACOUSTICS SPE-
ECH AND SIGNAL PROCESSING, Band ASSP-
30, Nr. 5, Oktober 1982, Seiten 709-718, IEEE,
New York, US; L. GAZSI: "Single chip filter
bank with wave digital filters"

N.T.Z.-ARCHIV, Band 7, Nr. 3, März 1985, Seiten 47-57, Berlin, DE; H. GÖCKLER:
"Einstellbare Digitalfilter für die Tontechnik"

IEEE TRANSACTIONS ON CIRCUITS AND SY-
STEMS, Band CAS-23, Nr. 10, Oktober 1976,
Seiten 624-630, New York, US; H.S. EL-
GHOROURY et al.: "Wave digital filter structures with variable frequency characteristics"

(73) Patentinhaber: **Blaupunkt-Werke GmbH
Robert-Bosch-Strasse 200
W-3200 Hildesheim(DE)**

(72) Erfinder: **Kunold, Ingo, Dipl.-Ing.
Ouerstrasse 25
W-4790 Paderborn(DE)**
Erfinder: **Meerkötter, Klaus, Prof. Dr. Ing.
Pohlweg 47-49
W-4790 Paderborn(DE)**

(74) Vertreter: **Eilers, Norbert, Dipl.-Phys.
Blaupunkt-Werke GmbH Robert-
Bosch-Strasse 200
W-3200 Hildesheim(DE)**

## Beschreibung

Gegenstand des Schutzrechts ist ein neuer Dämpfungsentzerrer mit zwei symmetrischen Wellendigitalfiltern.

Wellendigitalfilter sind unter anderem von A. Fettweis in proceedings of the IEEE VOL.74, 1986 "Wave Digital Filters: Theory and Practice" beschrieben worden. L. Gaszi beschreibt in "IEEE Transaction of Acoustics, Speech and Signal Processing", Band ASSP-30, Nr. 5, Oktober 1982, Seite 709 bis 718 in dem Aufsatz "Single Chip Filter Bank with Wave Digital Filters" Wellendigitalfilter mit zwei Ausgängen, an welchen Signale mit zueinander komplementären Frenquenzgängen abgreifbar sind.

Der Erfindung lag die Aufgabe zugrunde, für Dämpfungsentzerrer mit geringem Aufwand, insbesondere bei der Realisierung der Adaptionsalgorithmen, zu sorgen.

Diese Aufgabe wird durch die Merkmale des Hauptanspruchs gelöst.

Die Erfindung ist anhand mehrerer Figuren in der nachfolgenden Beschreibung näher erläutert.

Es zeigt:

Fig 1 eine schematische Darstellung eines symmetrischen Wellendigitalfilters,

Fig. 2 ein en Entzerrer

Fig. 3 ein symmetrisches Wellendigitalfilter in gegenüber Fig. 1 detaillierterer Darstellung,

Fig. 4 den Verlauf der Dämpfung eines Entzerrers nach Fig. 2 mit einem Wellendigitalfilter nach Fig. 3,

Fig. 5 ein erstes Ausführungsbeispiel, der Erfindung

Fig. 6 ein zweites Ausfuhrungsbeispiel und

Fig. 7 und Fig. 8 je einen für eine erfindungsgemäße Filteranordnung verwendbaren Allpaß.

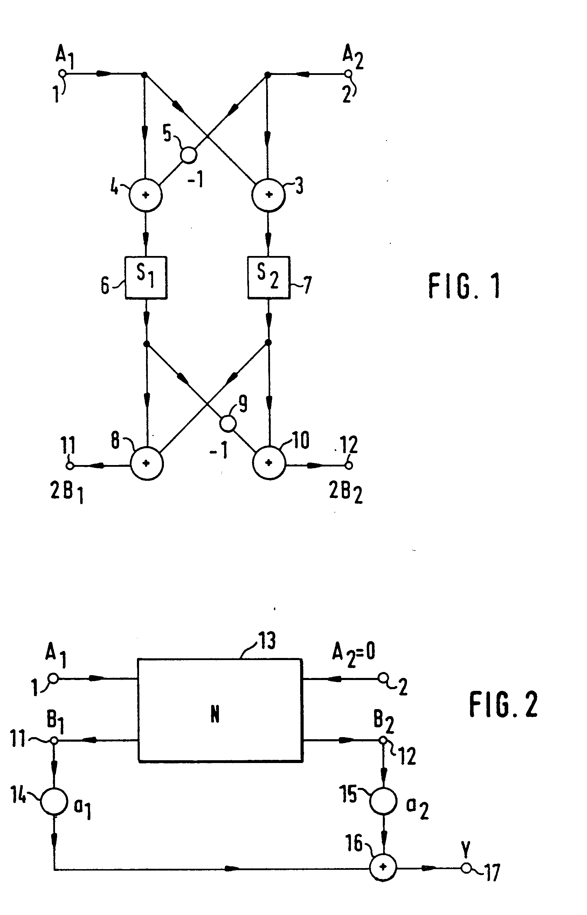

Gleiche Teile sind in den Figuren mit gleichen Bezugszeichen versehen. Die Figuren 1 bis 3 stellen im Falle einer Realisierung mit Signalprozessoren Flußdiagramme dar, können jedoch auch als Blockschaltbilder einer Hardware-Realisierung aufgefaßt werden.

Das in Fig. 1 dargestellte symmetrische Wellendigitalfilter weist zwei Eingänge 1, 2 auf, welchen Eingangssignale $A_1$ und $A_2$ zugeführt werden. Mit Hilfe eines ersten Addierers 3 werden die Eingangssignale addiert. Das Eingangssignal $A_1$ wird ferner einem zweiten Addierer 4 zugeführt, während das Eingangssignal $A_2$ über eine Vorzeichenumkehr 5 dem zweiten Addierer zugeleitet wird. Die Differenz und die Summe der Eingangssignale werden über je einen Allpaß mit der kanonischen Reflektanz $S_1$ bzw. $S_2$ geleitet. Mit Hilfe eines Addierers 8 werden die Ausgangssignale der Allpässe 6, 7 zu einem ersten Ausgangssignal $2B_1$ addiert und mit Hilfe einer Vorzeichenumkehr 9 und eines weiteren Addierers 10 zu einem zweiten Ausgangssignal $2B_2$ subtrahiert. In Fig. 2 sind die Ausgänge 11, 12 eines symmetrischen Wellendigitalfilters 13 über je einen Multiplizierer 14, 15 und einen Addierer 16 mit einem Ausgang 17 verbunden. Dem ersten Eingang 1 des Wellendigitalfilters 13 wird ein Eingangssignal $A_1$ zugeführt, während der Eingang 2 nicht mit einem Signal beaufschlagt ist.

Mit Hilfe der Multiplizierer 14, 15 werden die Ausgangssignale $B_1$ bzw. $B_2$ des Wellendigitalfilters 13 mit je einem Koeffizienten $a_1$ bzw. $a_2$ multipliziert. Das symmetrische Wellendigitalfilter 13 ist derart ausgeführt, daß die Strecke zwischen dem Eingang 1 und dem Ausgang 11 einen Frequenzgang aufweist, welcher zu dem Frequenzgang der Strecke zwischen dem Eingang 1 und dem Ausgang 12 invers ist. Ist also beispielsweise der Ausgang 11 ein Tiefpaßausgang, so ist der Ausgang 12 ein dazu komplementärer Hochpaßausgang. Mit Hilfe der den Multiplizierern 14, 15 zugeführten Koeffizienten $a_1$ und $a_2$ können die Komponenten des Ausgangssignals Y jeweils eines unteren und eines oberen Frequenzbereichs weitgehend unabhängig voneinander eingestellt werden.

Das Wellendigitalfilter N weist die Streumatrix

$$\underline{S} \;=\; \begin{bmatrix} s_{11} & s_{21} \\[2ex] s_{21} & s_{11} \end{bmatrix}$$

auf und sei derart entworfen, daß $S_{21}$ die Übertragungsfunktion eines Tiefpasses und $S_{11}$ die Übertragungsfunktion eines Hochpasses darstellt.

Das Ausgangssignal berechnet sich zu

$$Y = H(\Psi, a_1, a_2)A_1;$$

dabei ist $\Psi$ die äquivalente komplexe Frequenz.

Die Übertragungsfunktion $H(\Psi, a_1, a_2)$ ist dann durch

$$H(\Psi, a_1, a_2) = a_1 S_{11}(\Psi) + a_2 S_{21}(\Psi)$$

gegeben.

Für $a_1 = 0$ und $a_2 = 1$ ist H gleich $S_{21}$ und somit eine Tiefpaß-Übertragungsfunktion. Wird $a_1 = 1$ und $a_2 = 0$ gewählt, so stellt H die komplementäre Hochpaß-Übertragungsfunktion $S_{11}$ dar. Werden beide Koeffizienten gleich 1 gesetzt, so repräsentiert H die Übertragungsfunktion eines Allpasses. Aus denn aus $|S_{11}(j\phi)|^2 + |S_{21}(j\phi)|^2 = 1$ folgt $|S_{11}(j\phi) + S_{21}(j\phi)| = 1$, wenn $S_{11}(j\phi)$ und

$S_{21}(j\phi)$ orthogonal zueinander sind, d. h., wenn gilt

$$S_{11}S_{21}^* + S_{11}^* S_{21} = 0,$$

wobei der hochgestellte Stern die komplexe Konjugation kennzeichnet.

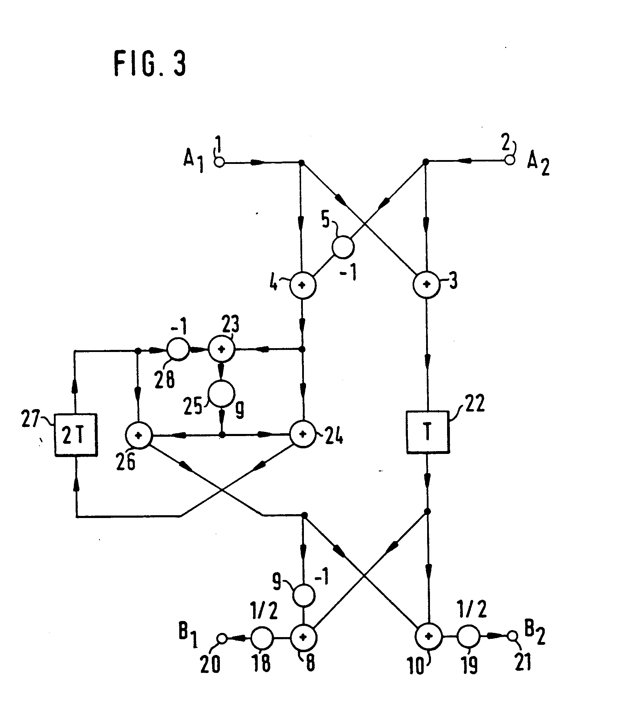

Bei dem in Fig. 3 dargestellten Wellendigitalfilter sind Beispiele für die Allpässe 6, 7 (Fig. 1) angegeben. Außerdem sind den Addierern 8, 10 Multiplizierer 18, 19 nachgeschaltet, welche durch Multiplikation mit 1/2 die erfolgte Verdoppelung der Amplituden rückgängig machen.

Während der eine Allpaß 22 durch eine Verzögerung um eine Abtastperiode T gebildet wird, weist der andere Allpaß die im folgenden beschriebene rekursive Struktur auf: Das Ausgangssignal des Addierers 4 wird zwei weiteren Addierern 23, 24 zugeführt. Das Ausgangssignal des Addierers 23 wird in einem Multiplizierer 25 mit einem Koeffizienten $g = 3/8$ multipliziert und dem Addierer 24 und einem weiteren Addierer 26 zugeleitet, dessen Ausgang den Ausgang des Allpasses bildet. Das Ausgangssignal des Addierers 24 wird um zwei Abtastperioden 2T bei 27 verzögert und dem Addierer 26 und nach Vorzeichenumkehr bei 28 dem Addierer 23 zugeleitet.

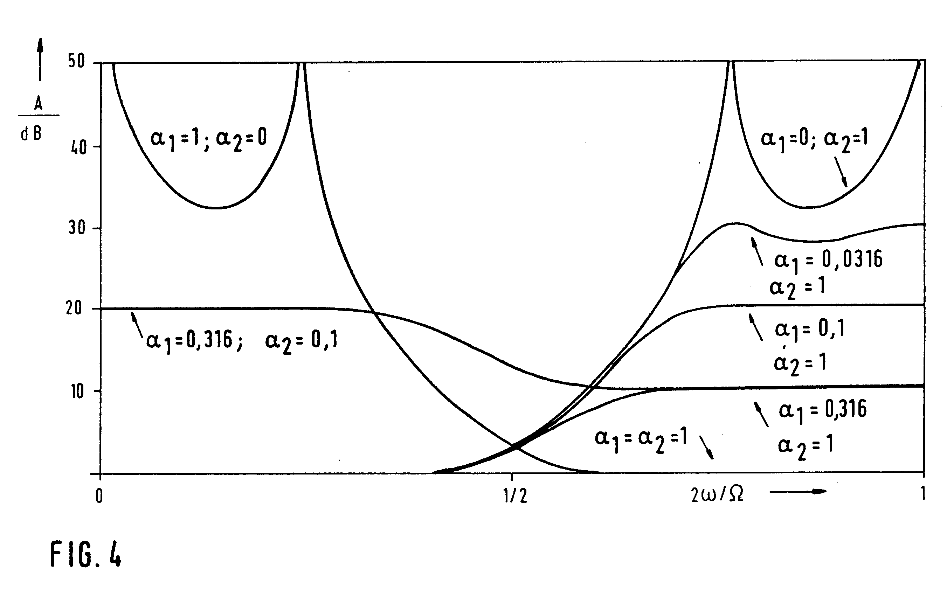

Fig. 4 stellt den Verlauf der Dämpfung A als Funktion der normierten Frequenz eines in Fig. 2 dargestellten Entzerrers dar, bei welchem ein Wellendigitalfilter gemäß Fig. 3 vorgesehen ist. Dabei ist ohne weiteres ersichtlich, daß die Dämpfung im oberen Frequenzbereich durch den Koeffizienten $a_1$ und im unteren Frequenzbereich durch den Koeffizienten a bestimmt ist. Für $a_1 = a_2 = 1$ beträgt die Dämpfung $A = 0$ dB. Mit kleiner werdendem Koeffizienten $a_1$ bzw. $a_2$ wird die Dämpfung in dem jeweiligen Frequenzbereich größer.

Der Verlauf der Dämpfung gemäß Fig. 4 weist einen relativ großen Übergangsbereich auf, in dem eine Beeinflussung durch beide Koeffizienten $a_1$ und $a_2$ stattfindet. Dieses ist auf die niedrige Ordnung des Wellendigitalfilters zurückzuführen, das lediglich einen Multiplizierer enthält. Bei Verwendung von Wellendigitalfiltern höherer Ordnung sind wesentlich kleinere Übergangsbereiche erzielbar.

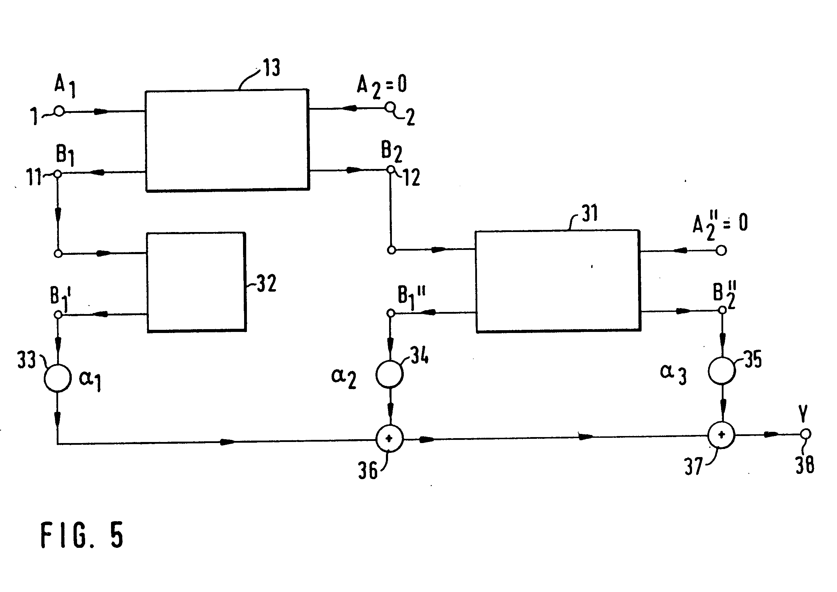

Durch Verwendung mehrerer Wellendigitalfilter ist eine Aufteilung des gesamten Frequenzbereichs in mehr als zwei Frequenzbereiche möglich. In Fig. 5 ist einem ersten Wellendigitalfilter 13 ein zweites Wellendigitalfilter 31 nachgeschaltet, mit dessen Hilfe das Ausgangssignal $B_2$ in Signale $B_1''$ und $B_2''$ mit unterschiedlichen Frequenzbereichen aufgespalten wird. Das Ausgangssignal $B_1$ des Wellendigitalfilters 13 wird zur Anpassung der Laufzeit des Wellendigitalfilters 31 über einen Allpaß 32 geleitet, dessen Ausgangssignal $B_1'$ mit Hilfe eines Multiplizierers 35 mit einem ersten Koeffizienten $a_1$ multipliziert wird. Die Ausgangssignale $B_1''$ und $B_2''$ des Wellendigitalfilters 31 werden mit Hilfe von Multiplizierern 34, 35 mit den Koeffizienten $a_2$ und $a_3$ multipliziert. Die Ausgangssignale der Multiplizierer werden dann bei 36 und 37 addiert und gelangen als Ausgangssignal Y zum Ausgang 38 der in Fig. 5 dargestellten Anordnung.

Der Allpaß 32 läßt sich durch eine Kaskadenschaltung von Verzögerungsgliedern realisieren, wenn die Wellendigitalfilter 13, 31 geeignet entworfen sind. Bei dem in Fig. 3 dargestellten Wellendigitalfilter trifft dieses zu.

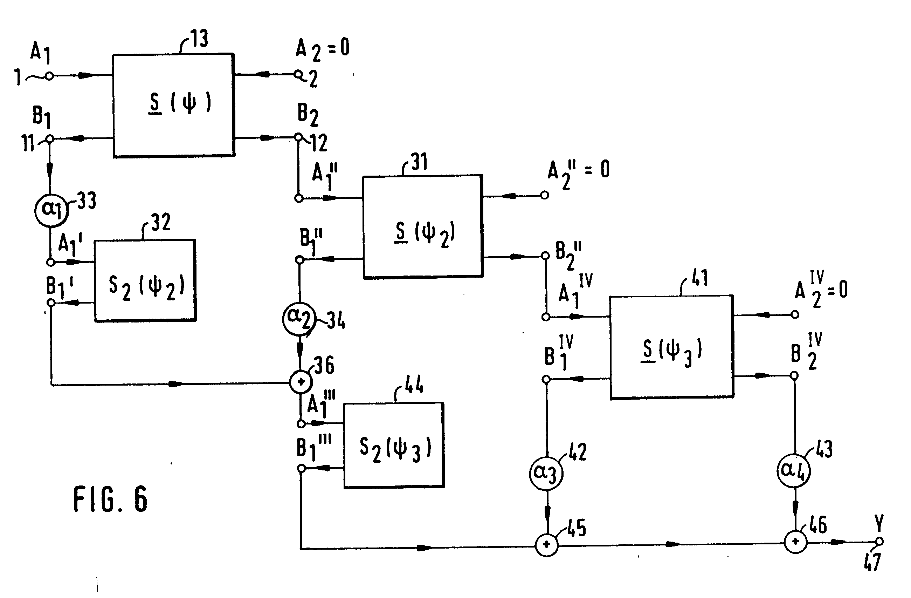

Reicht eine Aufteilung in drei Teilbänder nicht aus, so kann der Allpaß 32 durch ein weiteres Wellendigitalfilter ersetzt werden, so daß vier Teilbänder entstehen. Auch durch die in Fig. 6 dargestellte Filteranordnung ist eine weitere Aufteilung möglich. Dabei wird gegenüber der Anordnung nach Fig. 5 das Ausgangssignal $B_2''$ des Wellendigitalfilters 31 mit Hilfe eines weiteren Wellendigitalfilters 41 in zwei Frequenzbereiche aufgespalten. Jeder dieser Frequenzbereiche wird mit Hilfe der Multiplizierer 42 und 43 mit einem Koeffizienten $a_3$, $a_4$ bewertet. Zum Ausgleich der Laufzeit durch das weitere Wellendigitalfilter 41 ist ein weiterer Allpaß 44 vorgesehen. Die Addierer 45 und 46 fassen die Ausgangssignale des Allpasses 44 und des Wellendigitalfilters 41 zusammen und führen die Summe dem Ausgang 47 zu.

Eine Verschiebung des Allpasses 44 über die vorhergehende Additionsstelle 36 und auch über die Multiplizierer 33, 34 hinweg in die vorhergehenden Zweige ist ohne Änderung der Übertragungsfunktion möglich. Demgegenüber zeichnet sich die dargestellte Anordnung jedoch durch einen geringeren Hardwareaufwand aus.

Für die äquivalenten komplexen Frequenzen $\Psi_2$ und $\Psi_3$ gilt:

$$\Psi_2 = \frac{2\Psi}{1 + \Psi^2}$$

$$\Psi_3 = \frac{2\Psi_2}{1 + \Psi_2^2}$$

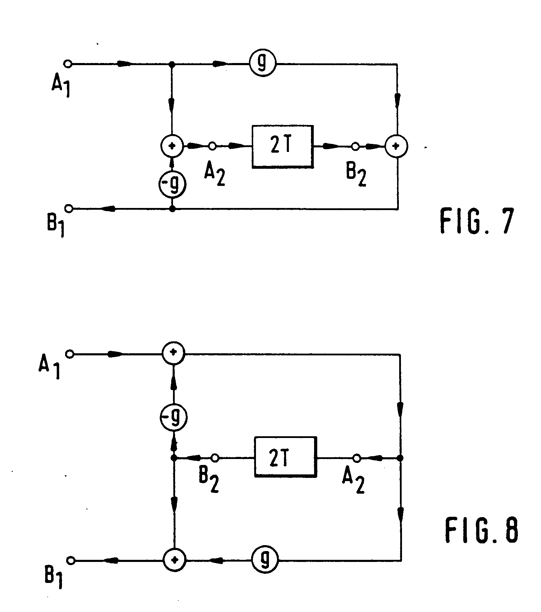

Die in Fig. 7 und Fig. 8 dargestellten Allpässe mit rekursiver Struktur eignen sich in besonders vorteilhafter Weise für erfindungsgemäße Dämpfungsentzerrer. Durch Transposition des Allpasses gemäß Fig. 7 erhält man einen äquivalenten Allpaß gemäß Fig. 8. Die gezeigten Allpässe stellen 2-Tor-Adaptoren dar, die mit 2T-Verzögerungen am zweiten Tor beschaltet sind.

Der Vorteil dieser Adaptoren besteht insbesondere darin, daß sie bei Einsatz von Signalprozessoren mit Multiplizierern schneller abgearbeitet werden können als die bisher bekannten Adaptoren.

Bei der Entzerrung von Audiosignalen ist eine Aufteilung in Teilbänder mit gleicher relativer Bandbreite vorteilhaft.

**Patentansprüche**

1. Dämpfungsentzerrer mit symmetrischen Wellendigitalfiltern (13, 31) mit zwei Eingängen und zwei Ausgängen, an welchen Signale mit zueinander komplementären Frequenzgängen abgreifbar sind,
dadurch gekennzeichnet,
daß der erste Eingang (1) eines ersten Wellendigitalfilters (13) mit dem zu entzerrenden Signal, der zweite Eingang (12) des ersten Wellendigitalfilters mit dem Signal "0" beaufschlagt ist, daß an dem einen Ausgang (12) des ersten Wellendigitalfilters der erste Eingang ($A_1$") eines zweiten Wellendigitalfilters (31), dessen zweiter Eingang mit dem Signal "0" beaufschlagt ist und an den anderen Ausgang (11) des ersten Wellendigitalfilters der Eingang eines Allpasses (32) angeschlossen ist, daß das Ausgangssignal des Allpasses (32) und beide Ausgangssignale des zweiten Wellendigitalfilters (31) über zugeordnete Multiplizierer (33, 34, 35) geleitet und danach in Addierstufen (36, 37) zum Ausgangssignal des Dämpfungsentzerrers zusammengeführt werden.

2. Dämpfungsempfänger nach Anspruch 1,
dadurch gekennzeichnet,
daß mehrere Netzwerke nach Anspruch 1 eine Kaskade bilden.

**Claims**

1. Attenuation equaliser having balanced wave digital filters (13, 31) with two inputs and two outputs, at which signals having mutually complementary frequency responses can be picked off, characterised in that the first input (1) of a first wave digital filter (13) has the signal which is to be equalised applied to it, and the second input (12) of the first wave digital filter has the signal "0" applied to it, in that the first input ($A_1$") of a second wave digital filter (31), whose second input has the signal "0" applied to it, is connected to the one output (12) of the first wave digital filter, and the input of an all-pass network (32) is connected to the other output (11) of the first wave digital filter, and in that the output signal of the all-pass network (32) and both output signals of the second wave digital filter (31) are passed via associated multipliers (33, 34, 35) and are thereafter combined in adder stages (36, 37) to form the output signal of the attenuation equaliser.

2. Attenuation equaliser according to Claim 1, characterised in that a plurality of networks according to Claim 1 form a cascade.

**Revendications**

1. Correcteur de distorsion d'atténuation à filtres à ondes, numérique, symétrique (13, 31), avec deux entrées et deux sorties fournissant des signaux à courbe de réponse complémentaire, caractérisé en ce que,
   - la première entrée (1) d'un premier filtre à ondes, numérique (13) reçoit le signal à corriger, la seconde entrée (13) du premier filtre à ondes, numérique reçoit le signal "0", la sortie (12) du premier filtre à ondes, numérique est relié à la première entrée ($A_1$") d'un second filtre à ondes numérique (31) dont la seconde entrée reçoit le signal "0" et l'autre sortie (11) du premier filtre à ondes, numérique est reliée à l'entrée d'un filtre passe-tout (32), le signal de sortie du filtre passe-tout (32) et les deux signaux de sortie du second filtre à ondes, numérique (31) sont envoyés dans deux multiplicateurs (33, 34, 35) pour être additionnés dans des étages d'addition (36, 37) et donner le signal de sortie du correcteur de distorsion d'affaiblissement.

2. Récepteur d'atténuation selon la revendication 1, caractérisé en ce que plusieurs réseaux selon la revendication 1 forment une cascade.

FIG. 1

FIG. 2

FIG. 3

FIG. 4

EP 0 256 286 B1

EP 0 256 286 B1

FIG. 5

FIG. 6

FIG. 7

FIG. 8